# EUROPEAN PATENT APPLICATION

(11) **EP 4 637 277 A1**
(43) Date of publication of application: **22.10.2025**
(21) Application number: 24315186.7
(22) Date of filing: 16.04.2024
(51) Int. Cl.: H05K 3/02, H05K 1/18, H01L 23/538, H01L 25/07, H02M 1/00, H05K 1/11, H05K 3/42, H05K 3/46

(54) **HALF BRIDGE PCB EMBEDDED PREPACKAGE CELL WITH DECOUPLING FUNCTION**

(71) Applicant: Mitsubishi Electric R&D Centre Europe B.V., 1119 NS Schiphol Rijk Amsterdam (NL); MITSUBISHI ELECTRIC CORPORATION, Chiyoda-ku Tokyo 100-8310 (JP)
(72) Inventor: Perrin, Rémi, 35708 RENNES CEDEX 7 (FR); Lefevre, Guillaume, 35708 RENNES CEDEX 7 (FR)
(74) Representative: Plasseraud IP

(57) **Abstract**

Semiconductor package (1) comprising at least a pair of power switch dies (11, 12) connected in series to form a half bridge switching CELL, said pair of power dies being connected in parallel with one or more RC snubber die (13) with a silicon substrate, said power switch dies and RC snubber die being embedded in a PCB (20) comprising a top copper layer (21), PCB epoxy laminate layers (22, 24) and a bottom copper layer (23) for forming a prepackaged half bridge switching cell, wherein first vias (33, 34, 35, 36, 37) in the PCB (22) interconnect connection pads of the dies and connection pads of said RC snubber component with tracks (S2h, S2, D2S1, D1, 51) made in at least one of said top copper layer and said bottom copper layer and wherein second vias (31, 32) to interconnect tracks on said top copper layer and tracks on said bottom copper layer, at least some tracks on said top copper layer providing further connection pads on said top copper layer to connect said semiconductor package to a further PCB, at least some tracks on said bottom layer providing cooling surfaces for said package.

## Description

### Technical Field

This disclosure pertains to the field of power electronics and more precisely the field of power modules packaging.

### Background Art

In power electronics, the packaging of dies of power devices and power modules is a crucial topic. In power modules, the package has multitude features. First, the package provides sealing and protection against external conditions (humidity, dust, etc...) for the power modules and the dies. In addition, it provides internal and external electrical connections for the dies and a thermal path to extract the heat out. The most common technology to package power dies is to attach them on a substrate such as a Direct Bonded Copper (DBC) or a lead frame, then connect the top pads of the dies with aluminum wires bonded using ultrasonic bonding process. The whole device is then molded within plastic-based materials or placed in a plastic box filled with silicone gel.

An emerging technology is to embed power devices such as power dies into a multilayer PCB laminate. The power device is inserted in cavities in the multilayer structure and laminated with it to form a single assembly. Afterwards, drillings which are most of the time made by laser beams permit to reach the pads of the power device and connect them by filling the holes with copper which is usually chemically then electrically deposited. Such interconnections are called vias. This technology has been used for converter assembly or used as a fanout for power devices.

Based on this assembly process a new category of packaging called prepackaging has been proposed by the company GaN Systems for example. Prepackage technique provides an intermediate solution in between a power module and a bare die and offers more flexibility than the bare die. Compatibility with mass production process at wafer level or at single die level is granted which ensures cost-effectiveness of this solution. However, the known prepackages are providing single semiconductor prepackages such as used in buck/boost designs and remain with high parasitic elements.

### Summary

In view of the above situation, the present disclosure proposes a semiconductor package comprising at least a pair of power switch dies connected in series to form a half bridge switching cell, said pair of power dies being connected in parallel with one or more RC snubber die with a silicon substrate, said power switch dies and RC snubber die being embedded in a PCB comprising a top copper layer, PCB epoxy laminate layers and a bottom copper layer for forming a prepackaged half bridge switching cell, wherein first vias in the PCB interconnect connection pads of the dies and connection pads of said RC snubber component with tracks made in at least one of said top copper layer and said bottom copper layer and wherein second vias to interconnect tracks on said top copper layer and tracks on said bottom copper layer, at least some tracks on said top copper layer providing further connection pads on said top copper layer to connect said semiconductor package to a further PCB, at least some tracks on said bottom layer providing cooling surfaces for said package.

The prepackaged half bridge switching cell with the one or more silicon RC snubber dies placed in parallel of the half bridge provide near decoupling function. The RC snubber near decoupling has the advantage of containing the switching loop to the close vicinity of power devices thus limiting the impact of stray elements located outside. This consequently provides cleaner switching transitions, with regards to EMI noise and overshoots. The integrated silicon RC snubber die has a temperature stability allowing it to be close to the power switches dies. Integration of the silicon snubber removes constrain when interconnecting the prepackage in a more complex topology and reduce the need to have a compact PCB layout for the half bridge complete cell.

The epoxy laminate layers may comprise a main laminate layer provided with openings to receive said dies.

The epoxy laminate layers may comprise an upper laminate layer above said main laminate layer.

The semiconductor package may comprise second laminate layers positioned in said openings above and under said dies.

The semiconductor package may comprise vias between said power dies and said RC snubber die and said top and bottom copper layers, said vias being formed in said upper laminate layer and said second laminate layers.

The main laminate layer is formed as a frame layer around said dies and said second laminate layers.

The semiconductor package may comprise, under said bottom copper layer, an electrically insulating and temperature conductive layer.

The semiconductor package may comprise a heatsink or a further copper layer under said electrically insulating and temperature conductive layer.

The RC snubber is preferably provided as a silicon substrate with at least a resistor and at least a capacitor made using holes in the substrate, insulating layers, conductive layers, and doped polysilicon layers deposits.

A resistive part of the RC snubber die near the power dies may provide a temperature sensitive element to be used as a temperature sensor to sense the temperature variation of the package, the package comprising connection pads for said temperature sensitive element.

A capacitive part of the RC snubber may provide a current sensitive element used to be used as a current sensor for a current sensor circuit, the package comprising connection pads for said current sensitive element.

The semiconductor package may comprise at least two pairs of power dies connected in parallel to form a half bridge with parallel power switches.

The present disclosure also concern a power electronics converter circuit comprising half bridges circuits made with semiconductor packages where a bottom side of said semiconductor packages comprising an electrically insulating layer under said bottom copper layer and a further copper layer under said electrically insulating layer, said further copper layer being soldered or sintered on a PCB of said power electronics converter circuit, connection wires connecting pads on a top side of said semiconductor packages to contact pads on said PCB of said power electronics converter circuit.

The power electronics converter circuit may comprise a conditioning circuit, wherein a resistive part of the RC snubber die near the power dies provides a temperature sensitive element used as a temperature sensor to sense the temperature variation of the package connected to said conditioning circuit through connecting pads on said semiconductor package connecting wires and connecting pads on said PCB of said power electronics converter circuit to provide and over temperature detection circuit.

The power electronics converter circuit may comprise an overcurrent and short-circuit protection circuit wherein a capacitive part of the RC snubber is used as a current sensitive element used as a current sensor for said current sensor circuit, current sensitive element being connected to said protection circuit through connection pads on said package, connecting wire and connection pads on said PCB of said power electronics converter circuit.

The present disclosure concerns further a power electronics converter circuit comprising half bridges circuits made with semiconductor packages according to the present disclosure, wherein contact pads of the upper face of the semiconductor packages are sintered or soldered on corresponding pads of a PCB of said power electronics converter circuit.

The present disclosure concerns also a method for manufacturing a package comprising a half bridge circuit with snubber comprising:
- providing cavities in a first prepreg to form a main laminate layer,
- placing at least two power dies to form a half bridge cell and at least one RC silicon snubber die in said cavities, said dies being located between second prepregs to form second laminate layers also received in said cavities,
- placing said first prepreg, said dies and second prepregs between an upper prepreg to form an upper laminate layer covered with an external copper sheet and a lower copper sheet,
- laminating said first prepreg, said second prepregs and said upper prepreg to form a core of the package with said upper copper sheet on an upper side, said upper laminate layer, said main laminate layer with embedded dies and second laminate layers and said lower copper sheet on a lower side of the package,
- drilling holes through said laminate layers and copper sheets between the upper side or the lower side and contact pads of said power dies and said RC snubber and between said copper sheets, said upper laminate layer and said main laminate layer,
- filling said holes with conductive material to provide vias between said power dies, said RC snubber die and the top and/or bottom sides of the package and also at selected locations between said upper copper sheet and lower copper sheet,
- etching the copper sheets to provide copper tracks and copper pads connected to said vias on said top and bottom sides of the package.

A configuration of the tracks and vias may be arranged to provide a serial connection of a drain of a first of said power dies and a source of a second of said power dies, a parallel connection of said power dies to said RC snubber, a connection of a source of said first of said power dies to a first connection pad of said package, a connection of a drain of said second of said power dies to a second connection pad of said package and connection of the gates of said power dies to further connection pads of said package.

The method may comprise adding a temperature conductive, electrically insulating layer under said bottom side of the package.

The method may comprise attaching a heatsink to said temperature conductive, electrically insulating layer or comprising attaching a further copper layer to said temperature conductive, electrically insulating layer.

The package provides a prepackage half bridge cell including a RC snubber. The prepackage is using a PCB having only two copper layers in order to be cost optimized and limit the number of interfaces for the thermal aspect. Additionally, this basic structure offers more flexibility to the end-user with regards to implementation or targeted applications.

### Brief Description of Drawings

Other features, details and advantages will be shown in the following detailed description and on the figures, on which:
Figure 1 shows a simplified schematics of a half bridge with RC snubber;
Figure 2A shows a partial exploded view of a semiconductor package made in accordance with the present disclosure;
Figure 2B shows another partial exploded view of a semiconductor package made in accordance with the present disclosure;
Figure 3 shows temperature on a semiconductor package made in accordance with the present disclosure;
Figure 4 shows an example of implementation of a semiconductor package according to the present disclosure on a converter PCB;
Figure 5 is a simplified schematic view of a half bridge element with gate control; '
Figure 6 is a simplified schematic view of the half bridge section of a three-phase converter using semiconductor packages of the present disclosure.

### Description of Embodiments

In the present disclosure, PCB epoxy laminate layer may be simplified in "epoxy laminate layer" or in "laminate layer".

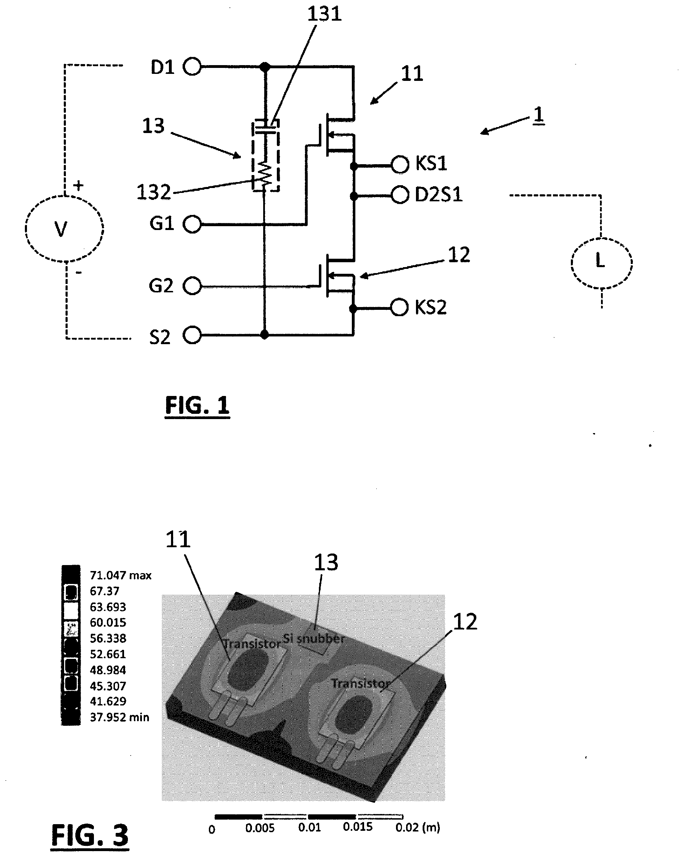

It is now referred to figure 1 which shows a simplified schematics of a half bridge having a top power switch 11 with Drain connection D1 which may be connected to a positive voltage of a voltage source, gate connection G1 to be connected to a gate driver, Kelvin source connection KS1, source connection S1. The source connection S1 is connected to the Drain connection D2 of a bottom power switch 12 having its gate connection G2, Kelvin source connection KS2 and source connection S2 which may be connected to a negative voltage of said voltage source. The output D2S1 common to the top switch source and bottom switch drain may be connected to a load L.

The half bridge is connected in parallel with a RC snubber 13 having a resistor element 131 and a capacitive element 132.

In the present disclosure, such devices are embedded in a PCB to provide a semiconductor package with the two semiconductor switches and the RC snubber which is also made with made out of a die having a silicon substrate.

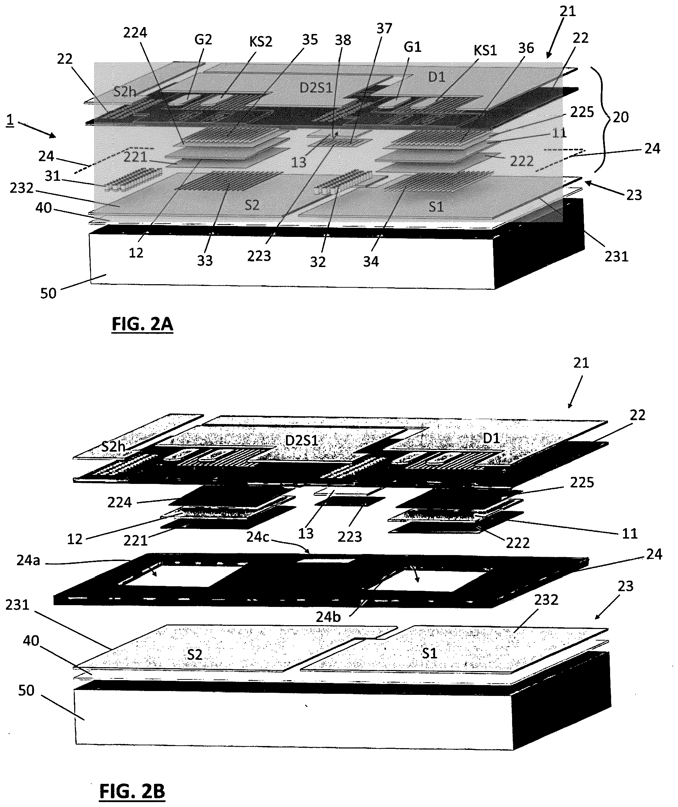

Figures 2A and 2B show an example of realization of such a semiconductor package 1 which comprises the power switch dies 11, 12 connected in series and connected in parallel with a RC snubber die 13 with a silicon substrate in order to form a prepackaged half bridge switching cell. In figure 2A a main epoxy layer is only shown as dotted partial lines to show the via arrangement, while in figure 2B such main epoxy layer 24 is shown while the vias are removed.

The power switch dies and RC snubber die are embedded in a PCB 20 comprising a top copper layer 21, an upper epoxy laminate 22, a main epoxy laminate 24 having openings to receive the dies 11, 12, 13 and epoxy laminate plates 221, 222, 223, 224, 225 and a bottom copper layer 23.

Vias in the PCB 22 interconnect connection pads of the dies and connection pads of said RC snubber component with tracks made in at least one of said top copper layer and said bottom copper layer.

In the design shown, vias 33 connect the bottom face of the bottom switch 11 to a copper track S2 232 in the bottom copper layer, vias 31 connect such track S2 to a track S2h of the top copper layer corresponding to the source pad to be connected to the power supply, vias 35 connect the drain on the top side of the bottom power switch die 12 to track D2S1 in the top copper layer and connect the gate and kelvin source of such die to contact pads G2 and KS2 on the top copper layer 21. Such track D2S1 is connected to the copper track S1 231 onto which is connected the source on the bottom side of power switch die 12 through vias 34. On the top power switch die 11 side, vias 36 connect the drain of the top side of the switch 11 to track D1 which is the drain pad of the half bridge to be connected to the power supply and connect the gate and Kelvin source on the top side of the upper power switch die 11 to pads G1 and KS1 on the top copper layer 21. The RC snubber is connected through vias 223 to the source track S2 and through vias not seen to the drain track D1 so that the RC snubber is in parallel with the half-bridge.

It should be noted that the vias above and under the dies are drilled in epoxy plates 221, 222, 223, 224, 225 and that one or more epoxy layers having openings to receive the dies are located under the epoxy layer 22 to enclose the dies after lamination.

In this drawing the semiconductor package comprises a thermally conductive, electrically insulating layer 40 under the bottom copper layer and a heatsink 50 under said thermally conductive layer.

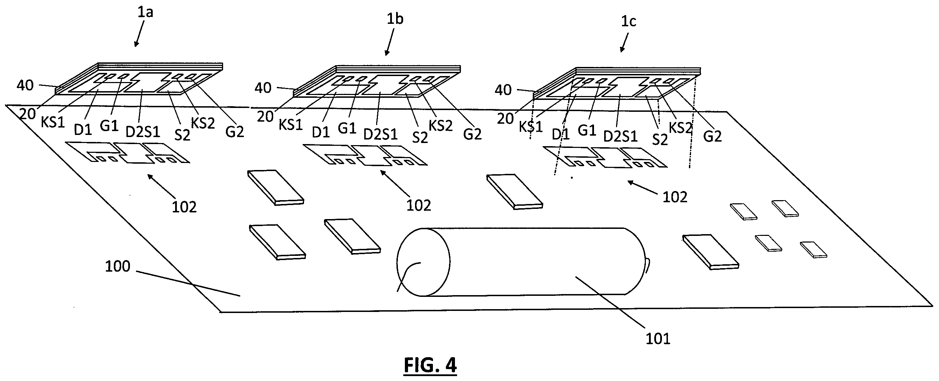

In the realization mode as shown in figure 4 concerning a three-phase converter with three semiconductors packages 1a, 1b, 1c, a further copper layer or an aluminum layer may be added under the thermally conductive layer 40 as a heatsink.

The thermally conductive, electrically insulating layer may be made of a prepreg ceramic filled, known as ceramic particle filled or ceramic particle doped prepreg layer, with a thermal conductivity of more than 1 W/m.K.

The advantages of the silicon RC snubber are the compatibility of assembly process with the two power dies due to the tunable thickness of such a die and the metallization of the RC snubber die. In addition, the temperature stability of the silicon substrate makes it compatible up to 250°C and capable of working in the vicinity of the die. Figure 3 shows an example of semiconductor package where the semiconductor switches made of transistors are under load to show the temperature repartition in the package. The RC snubber with silicon substrate also withstands high voltages e.g. 1500V. It usually has a thickness of 100 to 200 micrometers depending on the capacitive needs which are usually few nano Farads for high voltage rated snubber.

The variety of PCB design tools provide the needed support for the design part. The die metallization can be the same for all the dies, using same mask during clean room process for cost reduction, and then adapted during prepackaging step to each customer needs in terms of interconnection and thermal constraints.

The semiconductor package may provide a spreader function and ease connection of the gates of the dies. Parallelization is eased and the same package can fit different power levels. Potential of die size shrinkage, i.e. the number of guard rings on the sides of the die may be reduced, and the prepackage allows to counterbalance the gate pad size reduction on the dies. In addition, the die environment is improved since the epoxy PCB is a safer environment than air and has better ageing characteristic than potting. In comparison with transfer molded half bridges power modules, the prepackaged half bridge power modules are offering large scale production with large parallel production process, e.g. not limited by the mold size. The design of the present disclosure offers a functionalized prepackaged half bridge cell protected against electromagnetic interferences with interconnections adapted to the application and additional feature such as sensing, or decoupling can be added to the PCB.

The present design may be used in converters such as a three-phase inverter having three half bridges such as exemplified in figure 4 where an energy reserve capacitor 101 is far to the half bridges on a PCB 100 of such inverter and where the RC snubber damps overvoltage and parasitic ripple. The present semiconductor packages allow also to enlarge the PCB designs since the RC snubbers protect the half bridge switches from parasitic electrical perturbances.

in this example, the semiconductor packages are arranged upside down on the converter PCB and have their upper face soldered on the converter PCB with pads D1, G1, KS1, D2S1, S2, KS2, G3 of the semiconductor package soldered or sintered on corresponding pads 102 of the PCB 100 of the converter.

The bottom side of said semiconductor packages which comprises an electrically insulating layer 40 under the bottom copper layer and a further copper layer 51 under said electrically insulating layer is staying upwards to be thermally connected to a common heatsink for the three packages or to separate heatsinks for said packages.

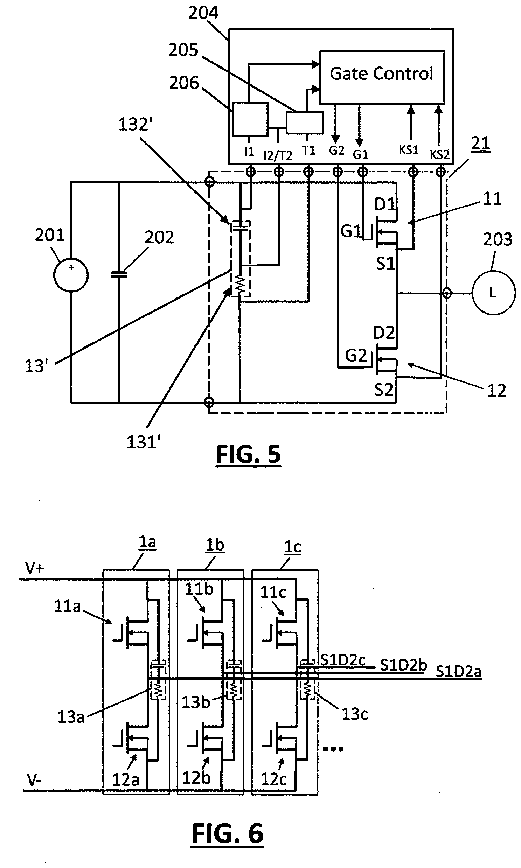

Figure 6 shows the three packages of figure 4 with their outputs S1D2a, S1D2b, S1D2c and the V+ and V- rails.

In the example of figure 5, a resistance 131' of the RC snubber die 13' near the power die in the package 21 provides a temperature sensitive element used as a temperature sensor to sense the temperature variation of the package connected to said conditioning circuit through connecting pads T1, T2 on said semiconductor package and connecting pads on a PCB of a gate control module 204 of a power electronics converter circuit to provide and over temperature detection circuit.

A capacitive part 132' of the RC snubber is used as a current sensitive element used as a current sensor for said current sensor circuit, current sensitive element being connected to said protection circuit through connection pads I1, I2 on said package and connecting pads on said PCB of said power electronics converter circuit gate control circuit 204.

A method for manufacturing such a package comprising a half bridge circuit with snubber according to the present disclosure comprises providing cavities 24a, 24b, 24c in a first prepreg to form a main PCB epoxy insulating laminate layer 24, hereafter main laminate layer 24 such as depicted in figure 2B, placing at least two power dies 11, 12 to form a half bridge cell and at least one RC silicon snubber die 13 in said cavities, said dies being located between second prepregs to form second PCB epoxy insulating laminate layers, hereafter second laminate layers, 221, 222, 223, 224, 225 also received in said cavities.

The method also comprises placing said first prepreg, said dies and second prepregs between an upper prepreg to form an upper PCB epoxy insulating laminate layer hereafter upper laminate layer 22 covered with an upper copper sheet 21 and a lower copper sheet 23 as depicted in figure 2A, where the first prepreg to form the main laminate layer 24 is only represented as partial dotted lines, to form after lamination a core of the package with a copper sheet 21 on an upper side, the upper epoxy laminate layer 22, said main laminate layer 24 with embedded dies 11, 12, 13 and second epoxy laminate layers 221, 222, 223, 224, 225 and a copper sheet 22 on a lower side of the package.

According to figure 2A, to provide interconnections in the package, holes are drilled through said epoxy laminates and copper sheets between the upper side or of the lower side and contact pads of said power dies and said RC snubber and filling said holes with conductive material to provide vias 31, 32, 33, 34, 35, 36, 37 between said power dies, said RC snubber die and the top and/or bottom sides of the package and also at selected locations between said upper copper sheet and lower copper sheet.

Then, the copper sheets are etched to provide copper tracks and copper pads such as thermal pads or connection pads which are connected to said vias on said top and bottom sides of the package. The configuration of the tracks is arranged to provide a serial connection of a drain of one of said power dies 11 and a source of a second of said power dies 12, a parallel connection of said power dies 11, 12 to said RC snubber 13, a connection of a source of said one of said power dies 11 to a first connection pad of said package, a connection of a drain of said second of said power dies 12 to a second connection pad of said package and connection of the gates of said power dies to further connection pads of said package.

According to an embodiment a temperature conductive, electrically insulating layer 40 is added under said bottom side of the package.

Then, according to use of the package, either a heatsink 50 is attached to said temperature conductive, electrically insulating layer or a further copper layer 51 is attached to said temperature conductive, electrically insulating layer.

### Industrial Applicability

The technical solutions presented here can be used to build inverters or converters in many application domains.

## Claims

1. - Semiconductor package (1) comprising at least a pair of power switch dies (11, 12) connected in series to form a half bridge switching cell, said pair of power dies being connected in parallel with one or more RC snubber die (13) with a silicon substrate, said power switch dies and RC snubber die being embedded in a PCB (20) comprising a top copper layer (21), PCB epoxy laminate layers (22, 24) and a bottom copper layer (23) for forming a prepackaged half bridge switching cell, wherein first vias (33, 34, 35, 36, 37) in the PCB (22) interconnect connection pads of the dies and connection pads of said RC snubber component with tracks (S2h, S2, D2S1, D1, 51) made in at least one of said top copper layer and said bottom copper layer and wherein second vias (31, 32) to interconnect tracks on said top copper layer and tracks on said bottom copper layer, at least some tracks on said top copper layer providing further connection pads on said top copper layer to connect said semiconductor package to a further PCB, at least some tracks on said bottom layer providing cooling surfaces for said package.

2. - Semiconductor package (1) according to claim 1 wherein said PCB epoxy laminate layers comprise a main laminate layer (24) provided with openings to receive said dies.

3. - Semiconductor package (1) according to claim 2 wherein said PCB epoxy laminate layers comprise an upper laminate layer (23) above said main laminate layer (24).

4. - Semiconductor package (1) according to claim 2 or 3 comprising second laminate layers (221, 222, 223, 224, 225) positioned in said openings above and under said dies.

5. - Semiconductor package (1) according to claim 4 comprising vias between said power dies (11, 12) and said RC snubber die (13) and said top and bottom copper layers, said vias being formed in said upper laminate layer (22) and said second laminate layers (221, 222, 223, 224, 225).

6. - Semiconductor package according to any one of the preceding claims, comprising, under said bottom copper layer (23), an electrically insulating and temperature conductive layer (40) and comprising further a heatsink (50) or a further copper layer under said electrically insulating and temperature conductive layer.

7. - Semiconductor package according to any one of the preceding claims, wherein the RC snubber (13) is provided as a silicon substrate with at least a resistor (131) and a capacitor (132) made using holes in the substrate, insulating layers, conductive layers, and doped polysilicon layers deposits.

8. - Semiconductor package according to claim 7, wherein a resistive part (131') of the RC snubber die (13') near the power dies provides a temperature sensitive element to be used as a temperature sensor to sense the temperature variation of the package, the package comprising connection pads (T1, T2) for said temperature sensitive element.

9. - Semiconductor package according to any one of the preceding claims, wherein a capacitive part (132') of the RC snubber (13') provides a current sensitive element to be used as a current sensor for a current sensor circuit, the package comprising connection pads (I1, I2) for said current sensitive element.

10. - Semiconductor package according to any one of the preceding claims, comprising at least two pairs of power dies (11, 12) connected in parallel to form a half bridge with parallel power switches.

11. - Power electronics converter circuit (100), **characterized in that** it comprises half bridges circuits made with semiconductor packages (1a, 1b, 1c) according to any one of the preceding claims, wherein contact pads (D1, G1, KS1, D2S1, S2, KS2, G2) of the upper face of the semiconductor packages are sintered or soldered on corresponding pads (102) of a PCB of said power electronics converter circuit (100).

12. - Method for manufacturing a package comprising a half bridge circuit with snubber comprising:
- providing cavities (24a, 24b, 24c) in a first prepreg to form a main laminate layer (24),
- placing at least two power dies (11, 12) to form a half bridge cell and at least one RC silicon snubber die (13) in said cavities, said dies being located between second prepregs to form second laminate layers (221, 222, 223, 224, 225) also received in said cavities,
- placing said first prepreg, said dies and second prepregs between an upper prepreg to form an upper laminate layer (22) covered with an external copper sheet (21) and a lower copper sheet (23),
- laminating said first prepreg, said second prepregs and said upper prepreg to form a core of the package with said upper copper sheet (21) on an upper side, said upper laminate layer (22), said main laminate layer (24) with embedded dies (11, 12, 13) and second laminate layers (221, 222, 223, 224, 225) and said lower copper sheet (22) on a lower side of the package,
- drilling holes through said laminate layers and copper sheets between the upper side or the lower side and contact pads of said power dies and said RC snubber and between said copper sheets, said upper laminate layer and said main laminate layer,
- filling said holes with conductive material to provide vias (31, 32, 33, 34, 35, 36, 37) between said power dies, said RC snubber die and the top and/or bottom sides of the package and also at selected locations between said upper copper sheet and lower copper sheet,
- etching the copper sheets to provide copper tracks and pads connected to said vias on said top and bottom sides of the package.

13. - Method according to claim 12 wherein a configuration of the tracks and vias is arranged to provide a serial connection of a drain of a first (11) of said power dies and a source of a second (12) of said power dies, a parallel connection of said power dies (11, 12) to said RC snubber (13), a connection of a source of said first (11) of said power dies to a first connection pad of said package, a connection of a drain of said second (12) of said power dies to a second connection pad of said package and connection of the gates of said power dies (11, 12) to further connection pads of said package.

14. - Method according to claim 12 or 13, comprising adding a temperature conductive, electrically insulating layer (40) under said bottom side of the package.

15. - Method according to claim 14, comprising attaching a heatsink (50) to said temperature conductive, electrically insulating layer or comprising attaching a further copper layer (51) to said temperature conductive, electrically insulating layer (40).
